# FASCICULE DE BREVET EUROPEEN

(11) **EP 3 227 956 B1**
(45) Date de publication et mention de la délivrance du brevet: **02.01.2019**
(21) Numéro de dépôt: 15801829.1
(22) Date de dépôt: 27.11.2015
(51) Int. Cl.: H01Q 1/02

(54) **DISPOSITIF ELECTRONIQUE POURVU D'UNE ANTENNE INTEGREE A UN DISSIPATEUR THERMIQUE**
ELEKTRONISCHE VORRICHTUNG MIT IN EINEM KÜHLKÖRPER INTEGRIERTER ANTENNE
ELECTRONIC DEVICE PROVIDED WITH AN ANTENNA INTEGRATED INTO A HEATSINK

(30) Priorité: 03.12.2014 FR 1461882
(43) Date de publication de la demande: 11.10.2017
(73) Titulaire: Sagemcom Broadband SAS, 92500 Rueil-Malmaison (FR)
(72) Inventeur: DEJARDIN, Romain, 92500 Rueil Malmaison (FR)
(74) Mandataire: Lavialle, Bruno François Stéphane
(86) Numéro de dépôt international: PCT/EP2015/077983
(87) Numéro de publication internationale: WO 2016/087335

(56) Documents cités:
- DE-U1-202009 001 821
- US-A1- 2014 139 400

## Description

La présente invention concerne la transmission de données par rayonnement électromagnétique.

Il existe des dispositifs électroniques comportant un boîtier renfermant notamment une carte électronique électriquement reliée à une antenne, et un dissipateur thermique pour évacuer les calories produites par un ou plusieurs des composants électroniques de la carte pendant leur fonctionnement. Le dissipateur thermique a une première face appliquée contre la carte électronique et, à l'opposé, une deuxième face en contact avec le boîtier.

L'antenne est généralement réalisée directement sur un bord de la carte électronique par gravure (par exemple antenne F inversée ou IFA) ou s'étend directement en saillie d'un bord de la carte électronique (par exemple antenne embarquée avec connecteur UFL).

Or, de nombreux dispositifs incorporent des éléments massifs et électriquement conducteurs, comme le dissipateur thermique, qui masquent partiellement l'antenne et en affectent la directivité et donc les performances. US2014/0139400 A1 et DE 20 2009 001821 U1 divulguent des dispositifs où l'antenne est disposée entre un dissipateur thermique et une surface d'un boîtier et où une portion du dissipateur thermique est en contact avec le boîtier.

Un but de l'invention est de fournir un dispositif électronique présentant de meilleures performances en transmission de données par rayonnement électromagnétique.

A cet effet, on prévoit, selon l'invention, un dispositif électronique comportant un boîtier renfermant une carte électronique et un dissipateur thermique. Le dissipateur thermique a une première face appliquée contre la carte électronique et à l'opposé une deuxième face dont une portion est en contact avec le boîtier. Une antenne est reliée électriquement à la carte électronique et s'étend à plat au moins en partie entre le dissipateur thermique et le boîtier. L'antenne s'étend autour de la portion de la deuxième face du dissipateur thermique en contact avec le boîtier.

Ainsi, l'antenne dispose d'un dégagement maximum en étant au plus proche de l'extérieur du boîtier et n'est pas masquée par le dissipateur thermique. Les dimensions de l'antenne sont aussi maximisées en exploitant au mieux une partie du volume disponible dans le boîtier.

De préférence, l'antenne est en contact avec le dissipateur thermique et le boîtier. Ceci améliore l'échange thermique entre le dissipateur et le boîtier.

De préférence encore, le dissipateur thermique est électriquement relié à une masse électrique de la carte.

Le dissipateur thermique peut être utilisé pour former un plan de référence de l'antenne. La référence formée par le dissipateur thermique n'est alors pas une référence flottante.

D'autres caractéristiques et avantages de l'invention ressortiront à la lecture de la description qui suit de modes de réalisation particuliers non limitatifs de l'invention.

Il sera fait référence aux dessins annexés, parmi lesquels :
- la figure 1 est une vue en perspective de l'antenne de ce dispositif,
- la figure 2 est une vue schématique, en coupe transversale partielle, d'un dispositif selon l'invention,
- la figure 3 est une vue de détail en coupe transversale de ce dispositif,
- la figure 4 est une vue analogue à la figure 2 d'un dispositif selon une variante de réalisation de l'invention.

En référence aux figures, le dispositif électronique selon l'invention comporte un boîtier 1 renfermant une carte électronique 2 et un dissipateur thermique 3 passif.

Le boîtier 1 est de type classique et a par exemple une forme globalement parallélépipédique. Le boîtier 1 est en matériau électriquement isolant, ici un matériau thermoplastique.

La carte électronique 2 comprend, de façon connue en soi, une plaque de circuit imprimé sur laquelle sont montés des composants électroniques. Le dispositif électronique comprend en outre une unité d'alimentation reliée à la carte électronique 2 et pourvue de moyens de son raccordement au réseau électrique, et une unité d'entrée/sortie permettant à la carte électronique 2 d'échanger des signaux avec l'extérieur.

Le dissipateur thermique 3 a une première face 4.1 appliquée contre les composants de la carte électronique 2 et à l'opposé une deuxième face 4.2 en contact avec le boîtier 1. Le dissipateur thermique 3 est en matériau électriquement conducteur, ici un métal tel que l'aluminium ou le cuivre, et est électriquement relié à la masse électrique de la carte électronique 2. Le dissipateur thermique 3 a ici une forme globalement de parallélépipédique et comprend quatre flancs formant un angle droit entre eux.

Le dispositif électronique comprend une antenne 5 reliée électriquement à l'unité d'entrée/sortie de la carte électronique 2.

L'antenne 5 s'étend à plat sur la deuxième face 4.2 du dissipateur thermique 3 entre ladite deuxième face 4.2 et la surface interne supérieure du boîtier 1. Plus précisément, l'antenne 5 comprend une couronne 5.1 reçue dans une rainure 4.3 ménagée dans la deuxième face 4.2 le long d'un pourtour de la deuxième face 4.2 du dissipateur thermique 3. L'antenne 5 s'étend ainsi autour de la portion centrale de la deuxième face 4.2 en contact avec le boîtier 1.

La couronne 5.1 s'étend selon un contour rectangulaire et possède deux bords extérieurs adjacents depuis chacun desquels au moins une portion rayonnante additionnelle 5.2 s'étend le long d'un flanc 4.4 du dissipateur 3.

L'antenne 5 est ici en tôle étamée ou en cuivre et a une épaisseur lui conférant une souplesse suffisante pour épouser la forme de la deuxième surface 4.2 du dissipateur thermique 3. L'antenne a une épaisseur de 0,5 mm environ et la rainure 4.3 a une profondeur légèrement inférieure ou égale à cette épaisseur. L'antenne est fixée au boîtier 1. La fixation est réalisée de façon connue en soi par bouterollage. Le boîtier 1 comprend des pions qui s'étendent en saillie de sa surface interne supérieure et qui sont reçus dans des trous réalisés dans l'antenne 5. Les pions ont une extrémité libre qui a été écrasée à chaud de manière à s'opposer au dégagement du pion hors du trou de l'antenne.

Pour que la dissipation thermique soit maximale, il faut qu'un maximum de la première face 4.1 du dissipateur thermique 3 soit en contact avec la carte électronique 2 et qu'un maximum de la deuxième face 4.2 du dissipateur thermique 3 soit en contact avec la surface interne supérieure du boîtier 1. De préférence, l'antenne 5 s'étend sensiblement dans le même plan que la deuxième face supérieure 4.2 pour être serrée entre le dissipateur thermique 3 et la surface interne supérieure du boîtier 1.

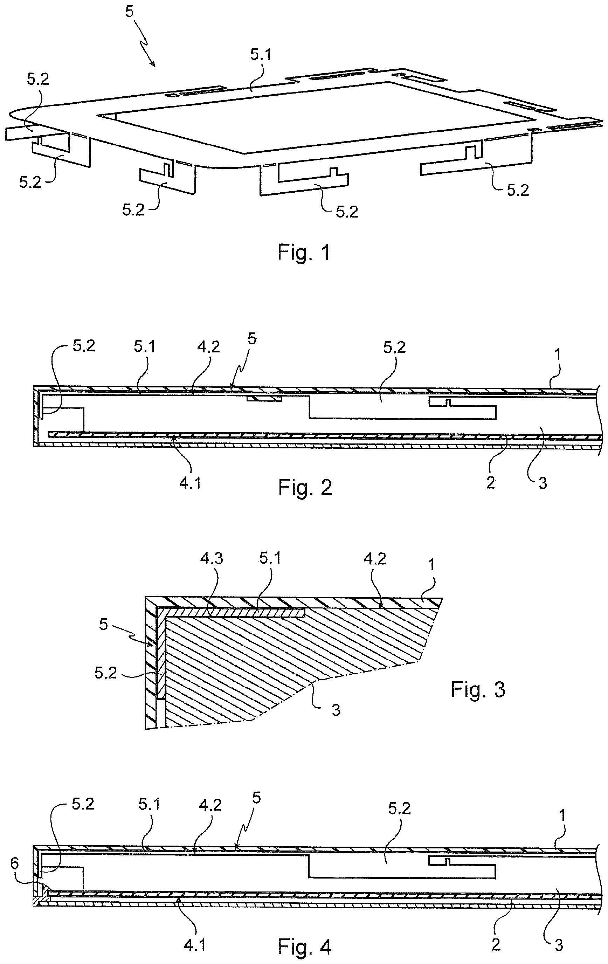

Dans la variante de la figure 3, l'antenne 5 est fixée au dissipateur thermique 3 qui est fixée sur la carte électronique 2 qui est clipée dans le boîtier 1 via des bras élastiques d'accrochage 6.

Bien entendu, l'invention n'est pas limitée aux modes de réalisation décrits mais englobe toute variante entrant dans le champ de l'invention telle que définie par les revendications.

En particulier, les formes du boîtier et du dissipateur thermique ne sont indiquées qu'à titre indicatif, d'autres formes étant possibles en fonction notamment d'une recherche esthétique pour ce qui concerne le boîtier ou d'une adaptation au volume interne disponible dans celui-ci pour ce qui concerne le dissipateur thermique.

Une portion seulement de la deuxième face du dissipateur thermique peut être en contact avec le boîtier, ou la totalité de la deuxième face.

L'antenne 5 peut être montée hors de toute rainure dans le cas où son épaisseur est faible.

La fixation de l'antenne 5 au boîtier 1 peut être réalisée par clipage.

La fixation de l'antenne 5 au dissipateur thermique 3 peut être réalisée par clipage : l'antenne 5 comprend des bras élastiques s'étendant depuis des bords extérieurs de la couronne 5.1 et ayant une extrémité libre pourvue d'un redan engagé dans un renfoncement du dissipateur thermique 3.

Bien que l'antenne ait été décrite avec des dimensions externes égales aux dimensions externes du dissipateur thermique, l'antenne peut avoir des dimensions externes inférieures ou supérieures aux dimensions externes du dissipateur thermique (dans ce dernier cas, l'antenne est fixée au boîtier et a des dimensions internes inférieures aux dimensions externes du dissipateur thermique pour être en contact avec celui-ci.

La forme de l'antenne 5 peut être différente de celle décrite. L'antenne 5 peut ainsi comprendre un nombre différent de portions rayonnantes additionnelles ou être dépourvues de telles portions rayonnantes additionnelles.

L'antenne peut être fixée par d'autres moyens et notamment par vissage, sertissage, serrage, coincement...

Le dissipateur thermique peut être dans un matériau non conducteur de l'électricité ou peut ne pas être relié à la masse de la carte électronique.

Le dispositif électronique peut comprendre plusieurs antennes.

## Revendications

1. Dispositif électronique comportant un boîtier (1) renfermant une carte électronique (2) et un dissipateur thermique (3) ayant une première face (4.1) appliquée contre la carte électronique et à l'opposé une deuxième face (4.2) dont une portion est en contact avec le boîtier, une antenne (5) étant reliée électriquement à la carte électronique et s'étendant à plat au moins en partie entre le dissipateur thermique et le boîtier et autour de la portion de la deuxième face en contact avec le boîtier.

2. Dispositif électronique selon la revendication 1, dans lequel l'antenne est en contact avec le dissipateur thermique et le boîtier.

3. Dispositif selon la revendication 1, dans lequel le dissipateur thermique (3) est électriquement relié à une masse électrique de la carte électronique.

4. Dispositif selon la revendication 1, dans lequel l'antenne (5) s'étend dans une rainure (4.3) ménagée le long d'un pourtour de la deuxième face (4.2) du dissipateur thermique (3).

5. Dispositif selon la revendication 4, dans lequel l'antenne (5) comporte une couronne (5.1) ayant un bord extérieur depuis lequel au moins une portion rayonnante (5.2) s'étend le long d'un flanc du dissipateur thermique (3).

6. Dispositif selon la revendication 5, dans lequel le dissipateur thermique (3) comprend deux flancs formant un angle entre eux et l'antenne (5) comporte au moins deux portions rayonnantes (5.2) s'étendant chacune le long d'un des flancs du dissipateur thermique (3).

7. Dispositif selon la revendication 1, dans lequel l'antenne (5) est fixée au boîtier (1).

8. Dispositif selon la revendication 7, dans lequel la fixation est réalisée par bouterollage.

9. Dispositif selon la revendication 1, dans lequel l'antenne (5) est fixée au dissipateur thermique (3).

## Patentansprüche

1. Elektronische Vorrichtung, umfassend ein Gehäuse (1), das eine Leiterplatte (2) und eine Wärmesenke (3) enthält, die eine erste Fläche (4.1) hat, die an der Leiterplatte anliegt, sowie entgegengesetzt dazu eine zweite Fläche (4.2), von der ein Abschnitt in Kontakt mit dem Gehäuse ist, wobei eine Antenne (5) elektrisch mit der Leiterplatte verbunden ist und sich zumindest teilweise zwischen der Wärmesenke und dem Gehäuse und um den mit dem Gehäuse in Kontakt stehenden Abschnitt der zweiten Fläche herum flach erstreckt.

2. Elektronische Vorrichtung nach Anspruch 1, bei der die Antenne in Kontakt mit der Wärmesenke und dem Gehäuse ist.

3. Vorrichtung nach Anspruch 1, bei der die Wärmesenke (3) elektrisch mit einer elektrischen Masse der Leiterplatte verbunden ist.

4. Vorrichtung nach Anspruch 1, bei der sich die Antenne (5) in einer Nut (4.3) erstreckt, die entlang eines Umfangs der zweiten Fläche (4.2) der Wärmesenke (3) ausgebildet ist.

5. Vorrichtung nach Anspruch 4, bei der die Antenne (5) einen Kranz (5.1) umfasst, der einen äußeren Rand hat, ab dem sich mindestens ein strahlender Abschnitt (5.2) entlang einer Flanke der Wärmesenke (3) erstreckt.

6. Vorrichtung nach Anspruch 5, bei der die Wärmesenke (3) zwei Flanken umfasst, die zwischen sich einen Winkel bilden und die Antenne (5) mindestens zwei strahlende Abschnitte (5.2) umfasst, die sich jeweils entlang einer der Flanken der Wärmesenke (3) erstrecken.

7. Vorrichtung nach Anspruch 1, bei der die Antenne (5) am Gehäuse (1) befestigt ist.

8. Vorrichtung nach Anspruch 7, bei der die Befestigung durch Stauchen erfolgt.

9. Vorrichtung nach Anspruch 1, bei der die Antenne (5) an der Wärmesenke (3) befestigt ist.

## Claims

1. Electronic device comprising a box (1) containing an electronic card (2) and a heatsink (3) having a first face (4.1) applied against the electronic card, and an opposite, second face (4.2) having a portion in contact with the box, an antenna (5) being electrically connected to the electronic card and extending flat at least in part between the heatsink and the box around the portion of the second face that is in contact with the box.

2. Electronic device according to claim 1, wherein the antenna is in contact with the heatsink and with the box.

3. Device according to claim 1, wherein the heatsink (3) is electrically connected to the electrical ground of the electronic card.

4. Device according to claim 1, wherein the antenna (5) extends in a groove (4.3) made along an outline of the second face (4.2) of the heatsink (3).

5. Device according to claim 4, wherein the antenna (5) comprises a ring (5.1) having an outer edge from which at least one radiating portion (5.2) extends along a flank of the heatsink (3).

6. Device according to claim 5, wherein the heatsink (3) has two flanks forming an angle between them and the antenna (5) has at least two radiating portions (5.2), each extending along a respective one of the flanks of the heatsink (3).

7. Device according to claim 1, wherein the antenna (5) is fastened to the box (1).

8. Device according to claim 7, wherein the fastening is achieved by heading.

9. Device according to claim 1, wherein the antenna (5) is fastened to the heatsink (3).
